# EUROPEAN PATENT SPECIFICATION

(11) **EP 4 297 103 B1**
(45) Date of publication and mention of the grant of the patent: **24.04.2024**
(21) Application number: 22186216.2
(22) Date of filing: 21.07.2022
(51) Int. Cl.: H01L 31/048, H01L 31/05

(54) **PHOTOVOLTAIC MODULE**
FOTOVOLTAIKMODUL
MODULE PHOTOVOLTAÏQUE

(30) Priority: 23.06.2022 CN 202210716629
(43) Date of publication of application: 27.12.2023
(73) Proprietor: Zhejiang Jinko Solar Co., Ltd., Haining, Zhejiang (CN); JINKO SOLAR CO., LTD, Shangrao Economic Development Zone Jiangxi Jiangxi 334100 (CN)
(72) Inventor: PENG, Yingying, Zhejiang (CN); CHEN, Shuya, Zhejiang (CN); HAO, Guohui, Zhejiang (CN)
(74) Representative: Novagraaf International SA

(56) References cited:
- EP-A1- 2 657 982
- CN-A- 112 864 265
- CN-U- 202 443 983
- US-A- 5 733 382
- US-A1- 2015 047 706

## Description

### TECHNIC FIELD

Embodiments of the present disclosure relate in general to a photovoltaic cell, and more specifically to a photovoltaic module.

### BACKGROUND

Photovoltaic modules, also known as solar panels, generate electricity through photovoltaic effect, which are the core of solar power systems. The photovoltaic module is generally composed of a cell, a cover plate, and an adhesive film for encapsulating front and rear surfaces of the cell so as to protect the cell.

However, conventional photovoltaic modules have poor performance. It is found that one of the reasons for the poor performance of the photovoltaic module is that the adhesive film not only has the effect of encapsulating the cell, but also reflects light incident on a surface of the cell so as to re-reflect the light into the cell. Generally, in actual preparation of the photovoltaic module, it is found that thicknesses of adhesive films on both sides of the cell affect reflection capability of the adhesive films, so as to affect light absorption capability of the cell, thus resulting in the poor performance of the photovoltaic module.

European patent application EP2657982A1 is directed to provide a method for producing a solar cell module and such a solar cell module that can suppress one portion of a sealing resin from protruding onto the peripheral portion of a surface protective member and a rear surface protective member even when the thickness of the tab wire is made thicker, and achieves a high output, with superior long-term reliability being also achieved.

Chinese invention application CN112864265A is to provide an anti-cracking photovoltaic stack welding module and its preparation process, so as to completely solve the negative consequences of the hidden cracks on the power generation and service life, and at the same time, to improve its operability, practical application and efficiency of industrial production.

### SUMMARY

Some embodiments of the present disclosure provide a photovoltaic module, which is at least conducive to improving performance of the photovoltaic module. The present invention is set out in the appended set of claims.

Some embodiments of the present disclosure provide a photovoltaic module including: a first cover plate, a first adhesive film, a plurality of cells, a second adhesive film, and a second cover plate; where a thickness of each respective cell of the plurality of cells is in a range of 100 µm to 170 µm, a thickness of the first adhesive film is in a range of 300 µm to 550 µm, a thickness of the second adhesive film is in a range of 300 µm to 710 µm, and the thickness of the first adhesive film and the thickness of the second adhesive film satisfy the following relationship: 0.0007x²-0.4297x+374.2≤y≤0.0034x²-1.0297x+314.19, where x is denoted as the thickness of the first adhesive film, and y is denoted as the thickness of the second adhesive film; the photovoltaic module further including at least one welding strip, where for each respective welding strip of the at least one welding strip, one end of the each respective welding strip is disposed on a front surface of one of two adjacent cells in the plurality of cells, and the other end of the each respective welding strip is disposed on a rear surface of the other of the two adjacent cells, where a thickness of the each respective welding strip is in a range of 200 µm to 400 µm. The first cover plate is made of glass, has a first surface facing the plurality of cells, and is provided with an embossing structure on the first surface, the embossing structure is recessed in a direction away from the each respective cell, and a recess depth of the embossing structure is in a range of 30 µm to 50 µm.

In some embodiments, at least one of a thickness difference between the each respective cell and the first adhesive film and a thickness difference between the each respective cell and the second adhesive film is in a range of 200 µm to 350 µm.

In some embodiments, a material of the second cover plate includes a back plate, the first adhesive film is disposed between the first cover plate and the plurality of cells, the second adhesive film is disposed between the second cover plate and the plurality of cells, and the thickness of the second adhesive film is less than or equal to the thickness of the first adhesive film.

In some embodiments, a thickness of the first cover plate is in a range of 2.7 mm to 3.2 mm, and a thickness of the back plate is in a range of 0.2 mm to 0.33 mm.

In some embodiments, the thickness of the first adhesive film is in a range of 330 µm to 510 µm, and the thickness of the second adhesive film is in a range of 310 µm to 500 µm.

In some embodiments, a material of the second cover plate includes glass.

In some embodiments, both a thickness of the first cover plate and a thickness of the second cover plate are in a range of 1.5 mm to 2 mm.

In some embodiments, the thickness of the first adhesive film is in a range of 310 µm to 500 µm, and the thickness of the second adhesive film is in a range of 310 µm to 520 µm.

In some embodiments, one of a thickness difference between the each respective welding strip and the first adhesive film and a thickness difference between the each respective welding strip and the second adhesive film is in a range of 50 µm to 180 µm.

In some embodiments, the first adhesive film includes at least one of a poly olefin elastomer, POE, adhesive film and an ethylene vinyl acetate, EVA, adhesive film, and the second adhesive film includes at least one of the POE adhesive film and the EVA adhesive film.

In some embodiments, the thickness of the first adhesive film is equal to the thickness of the second adhesive film when both the first adhesive film and the second adhesive film include POE adhesive films.

In some embodiments, a thickness of the first cover plate is greater than a thickness of the second cover plate; preferably, the thickness of the first cover plate is in a range of 1.8 mm to 2 mm, and the thickness of the second cover plate is in a range of 1.5 mm to 1.7 mm.

In some embodiments, a shape of the each respective welding strip is any one of circular, rectangular, trapezoidal and triangular.

In some embodiments, adjacent two cells in the plurality of cells are partially overlapped, and a shape of a portion of the each respective welding strip corresponding to an overlapping portion of the adj acent two cells is flat; optionally, the plurality of cells are disposed in parallel to each other, and a shape of a portion of the each respective welding strip disposed between two parallel cells in the plurality of cells is flat.

### BRIEF DESCRIPTION OF THE DRAWINGS

One or more embodiments are described as examples with reference to the corresponding figures in the accompanying drawings, and the examples do not constitute a limitation to the embodiments. The figures in the accompanying drawings do not constitute a proportion limitation unless otherwise stated.
FIG. 1 is a schematic cross-sectional view of a photovoltaic module according to an embodiment of the present disclosure.
FIG. 2 is another schematic cross-sectional view of a photovoltaic module according to an embodiment of the present disclosure.
FIG. 3 is still another schematic cross-sectional view of still another photovoltaic module according to an embodiment of the present disclosure.

### DETAILED DESCRIPTION OF THE EMBODIMENTS

Embodiments of the present disclosure provide a photovoltaic module including a first cover plate, a first adhesive film, a plurality of cells, a second adhesive film, and a second cover plate. A thickness of each respective cell of the plurality of cells is in a range of 100 µm to 170 µm, a thickness of the first adhesive film is in a range of 300 µm to 550 µm, a thickness of the second adhesive film is in a range of 300 µm to 710 µm, and the thickness of the first adhesive film and the thickness of the second adhesive film satisfy the following relationship: 0.0007x²-0.4297x+374.2≤y≤0.0034x²-1.0297x+314.19, where x is denoted as the thickness of the first adhesive film, and y is denoted as the thickness of the second adhesive film. In this way, the thickness of the first adhesive film and the thickness of the second adhesive film are adapted to the thickness of each respective cell, respectively, so that the first adhesive film and the second adhesive film have better absorption capability for incident light, utilization and absorption of incident light by the cell are improved, thereby improving photoelectric conversion performance of the photovoltaic module. In addition, each respective welding strip is disposed on the surface of the each respective cell, and the thickness of the each respective welding strip is in a range of 200 µm to 400 µm, so that the thickness of the each respective welding strip is adapted to the thickness of the first adhesive film and the thickness of the second adhesive film. In this way, the first adhesive film or the second adhesive film disposed on the surface of the welding strip has a better absorption capacity for incident light.

Various embodiments of the present disclosure are described in detail below with reference to the accompanying drawings. However, those of ordinary skill in the art should appreciate that many technical details have been proposed in various embodiments of the present disclosure for better understanding of the present disclosure. However, the technical solutions claimed in the present disclosure are able to be realized even without these technical details as well as various changes and modifications based on the following embodiments.

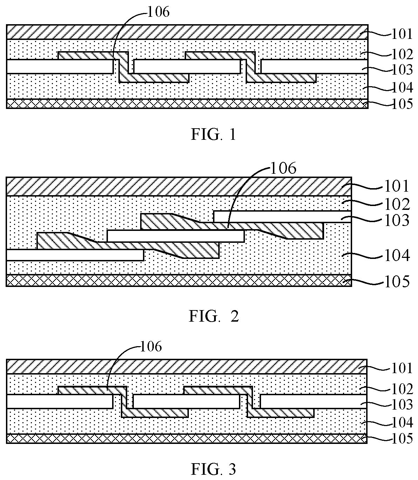

FIG. 1 is a schematic cross-sectional view of a photovoltaic module according to an embodiment of the present disclosure.

Referring to FIG. 1, the photovoltaic module includes a first cover plate 101, a first adhesive film 102, a plurality of cells 103, a second adhesive film 104, and a second cover plate 105. A thickness of each respective cell of the plurality of cells 103 is in a range of 100 µm to 170 µm, a thickness of the first adhesive film 102 is in a range of 300 µm to 550 µm, a thickness of the second adhesive film 103 is in a range of 300 µm to 710 µm, and the thickness of the first adhesive film 102 and the thickness of the second adhesive film 104 satisfy the following relationship: 0.0007x²-0.4297x+374.2≤y≤0.0034x²-1.0297x+314.19, where x is denoted as the thickness of the first adhesive film 102, and y is denoted as the thickness of the second adhesive film 104. The photovoltaic module further includes at least one welding strip 106. For each respective welding strip 106 of the at least one welding strip 106, one end of the each respective welding strip 106 is disposed on a front surface of one of two adjacent cells 103 in the plurality of cells 103, and the other end of the each respective welding strip 106 is disposed on a rear surface of the other of the two adjacent cells 103. A thickness of the each respective welding strip 106 is in a range of 200 µm to 400 µm.

For each respective cell 103 of the plurality of cells 103, the cell 103 is configured to absorb photons in incident light and generate electron-hole pairs which are separated by a built-in electric field in the cell 103 and generate potential at both ends of a PN junction, thereby converting light energy into electric energy. In some embodiments, one of surfaces of the cell 103 serves as a light receiving surface for absorbing incident light. In other embodiments, both surfaces of the cell 103 serve as light receiving surfaces for absorbing incident light. In some embodiments, the cell 103 may be a crystalline silicon solar cell, such as a single crystal silicon solar cell or a polysilicon solar cell. A plurality of cells 103 are provided, in some embodiments, the plurality of cells 103 may be electrically connected in a form of a whole piece or a plurality of pieces (e.g., a plurality of pieces such as 1/2 equal pieces, 1/3 equal pieces, 1/4 equal pieces, etc.) to form a plurality of cell strings. The plurality of cell strings are electrically connected in series and/or in parallel.

The thickness of the cell 103 is configured to be in a range of 100 µm to 170 µm. Within this range, the thickness of the cell 103 is small, so that an overall weight of the cell 103 is able to be reduced, thereby light weighting the photovoltaic module.

The first adhesive film 102 and the second adhesive film 104 are disposed on opposite surfaces of the cell 103 for encapsulating the cell 103, and the cell 103 may be bonded to the first cover plate 101 and the second cover plate 105. The incident light reaches the surface of the cell 103 via the first adhesive film 102 or the second adhesive film 104 when being irradiated onto the surface of the photovoltaic module. Based on the thickness of the cell 103, the thickness of the first adhesive film 102 is configured to be in a range of 300 µm to 550 µm, and the thickness of the second adhesive film 104 is configured to be in a range of 300 µm to 710 µm. Within this range, the thicknesses of the first adhesive film 102 and the second adhesive film 104 are adapted to the thickness of the cell 103. That is, on the one hand, the thicknesses of the first adhesive film 102 and the second adhesive film 104 are relatively large, so that the first adhesive film 102 and the second adhesive film 104 have a better encapsulation effect on the cell 103, thereby effectively preventing water vapor from entering the cell 103 and causing the failure of the cell 103. On the other hand, within this range, the thicknesses of the first adhesive film 102 and the second adhesive film 104 are not excessively large, so that the first adhesive film 102 and the second adhesive film 104 have a better absorption effect on the incident light, thereby enhancing utilization of the incident light by the cell 103. In addition, the configuration of the thicknesses of the first adhesive film 102 and the second adhesive film 104 within this range makes the amount of prepared first adhesive film 102 and second adhesive film 104 small, which is not only conducive to lightweight of the photovoltaic module, but also reduces the production cost. It should be noted that the thickness of the first adhesive film 102 and the thickness of the second adhesive film 104 respectively refer to the thickness of the first adhesive film 102 on the surface of the cell 103 and the thickness of the second adhesive film 104 on the surface of the cell 103.

In some embodiments, at least one of a thickness difference between the cell 103 and the first adhesive film 102 and a thickness difference between the cell 103 and the second adhesive film 104 is in a range of 200 µm to 350 µm. Within this range, the thickness difference between the first adhesive film 102 and the cell 103 or between the second adhesive film 104 and the cell 103 is relatively large, i.e., the thicknesses of the first adhesive film 102 and the second adhesive film 104 disposed on the surface of the cell 103 are relatively large. On the one hand, the first adhesive film 102 and the second adhesive film 104 are able to seal the cell 103 better, and water vapor is better prevented from entering the cell 103, thus the first adhesive film 102 and the second adhesive film 104 have a better potential induced degradation (PID) resistance effect. On the other hand, within this range, the thicknesses of the first adhesive film 102 and the second adhesive film 104 disposed on the surface of the cell 103 are not excessively large, so that the first adhesive film 102 and the second adhesive film 104 have a better absorption effect on the incident light, thereby improving the utilization of the incident light by the cell 103.

Specifically, in some embodiments, the thickness difference between the first adhesive film 102 and the cell 103 may be in a range of 200 µm to 350 µm. In some embodiments, the thickness difference between the second adhesive film 104 and the cell 103 may be in a range of 200 µm to 350 µm. In some embodiments, both the thickness difference between the first adhesive film 102 and the cell 103 and the thickness difference between the second adhesive film 104 and the cell 103 may be in a range of 200 µm to 350 µm.

When both opposite surfaces of the cell 103 serve as light receiving surfaces to absorb incident light, partial incident light is reflected by the first adhesive film 102 or the second adhesive film 104 at the time the incident light is irradiated onto any one of the first adhesive film 102 or the second adhesive film 104, and the reflected incident light is reflected to the other of the first adhesive film 102 or the second adhesive film 104 by a bottom surface, or diffracted to the other of the first adhesive film 102 or the second adhesive film 104 through surrounding environment, thereby being re-absorbed and utilized by the other of the first adhesive film 102 or the second adhesive film 104. The thicknesses of the first adhesive film 102 and the second adhesive film 104 have a great effect on the absorption rate of the incident light. For example, the larger the thicknesses of the first adhesive film 102 and the second adhesive film 104, the smaller the absorption rate of the incident light by the first adhesive film 102 and the second adhesive film 104.

Based on the above analysis and the thicknesses of the first adhesive film 102, the second adhesive film 104 and the cell 103, the thickness of the first adhesive film 102 and the thickness of the second adhesive film 104 is configured to satisfy the following relationship: 0.0007x²-0.4297x+374.2≤y≤0.0034x²-1.0297x+314.19, where x is denoted as the thickness of the first adhesive film 102, and y is denoted as the thickness of the second adhesive film 104. When the first adhesive film 102 and the second adhesive film 104 satisfy the relationship, the thickness of the first adhesive film 102 is adapted to the thickness of the second adhesive film 104, and the thickness of the first adhesive film 102 and the thickness of the second adhesive film 104 are adapted to the thickness of the cell 103, respectively, so that the absorption rate of the other of the first adhesive film 102 or the second adhesive film 104 to the reflected incident light is relatively large when the incident light irradiated onto the first adhesive film 102 or the second adhesive film 104 is reflected to the other of the first adhesive film 102 or the second adhesive film 104, thereby improving the absorption and utilization of the incident light by the photovoltaic module. For example, when the incident light is irradiated onto the surface of the first adhesive film 102, partial incident light is reflected by the bottom surface to the surface of the second adhesive film 104 or is diffracted by the surrounding environment to the surface of the second adhesive film 104, so that the partial incident light is able to be re-absorbed and utilized by the second adhesive film 104.

In some embodiments, the first adhesive film 102 includes at least one of a poly olefin elastomer (POE) adhesive film or an ethylene vinyl acetate (EVA) adhesive film, and the second adhesive film 104 includes at least one of the POE adhesive film or the EVA adhesive film. The POE adhesive film has excellent moisture barrier capability and ion barrier capability and does not produce acid in an aging process, thereby having excellent anti-aging performance and anti-PID effect. The EVA adhesive film makes the incident light in a short-wave band pass through more smoothly, thereby improving the absorption and utilization of the incident light by the cell 103. In some embodiments, both the first adhesive film 102 and the second adhesive film 104 may be POE adhesive films. In some embodiments, both the first adhesive film 102 and the second adhesive film 104 may be EVA adhesive films. In some embodiments, both the first adhesive film 102 and the second adhesive film 104 may include a material of both POE and EVA. For example, both the first adhesive film 102 and the second adhesive film 104 are composite adhesive films, and the composite adhesive film is composed of the POE adhesive film and the EVA adhesive film.

In some embodiments, when both the first adhesive film 102 and the second adhesive film 104 are POE adhesive films, the thickness of the first adhesive film 102 is equal to the thickness of the second adhesive film 104. The thickness of the first adhesive film 102 is the same as the thickness of the second adhesive film 104, so that the first adhesive film 102 and the second adhesive film 104 have the same water vapor barrier capability and ion barrier capability to the two opposite surfaces of the cell 103, thereby having a better encapsulation effect on the entire structure of the cell 103 and maintaining better performance of the cell 103.

The at least one welding strip 106 is further provided. Specifically, in some embodiments, for each respective welding strip 106 of the at least one welding strip 106, the welding strip 106 is disposed on surfaces of grid lines on the cell 103 and connects two adjacent cells 103 so that the two adjacent cells 103 are electrically connected. The welding strip 106 is coated with the first adhesive film 102 or the second adhesive film 104 so that the first adhesive film 102 and the second adhesive film 104 are able to firmly bond the welding strip 106 to the surface of the cell 103. The thickness of the welding strip 106 is configured to be in a range of 200 µm to 400 µm based on the thicknesses of the first adhesive film 102 and the second adhesive film 104, so that the thickness of the welding strip 106 is adapted to the thicknesses of the first adhesive film 102 and the second adhesive film 104, so that the first adhesive film 102 or the second adhesive film 104 disposed on the surface of the welding strip 106 has a better absorption capacity for the incident light, thereby improving performance of the whole photovoltaic module.

Referring to FIG. 1, in some embodiments, the plurality of cells 103 in the photovoltaic module are spaced apart and disposed in parallel. FIG. 1 shows an example of the plurality of cells 103 being disposed in parallel along a horizontal line, and in some embodiments, the plurality of cells 103 may also be disposed in parallel along a vertical line. The welding strip 106 forms an electrical connection between the two adjacent cells 103 by connecting opposite two surfaces of the two adjacent cells 103 respectively (i.e., one end of the welding strip 106 is connected to a front surface of one of the two adjacent cells 103, and the other end of the welding strip 106 is connected to a rear surface of the other of the two adjacent cells 103). A shape of the welding strip 106 may be any of circular, rectangular, trapezoidal, or triangular. The welding strip 106 having the above shape has a large thickness, which improves current transmission performance of the welding strip 106.

Referring to FIG. 2, in some embodiments, the plurality of cells 103 in the photovoltaic module are spaced apart, and adjacent two cells 103 are partially overlapped such that the spacing between the two cells 103 is relatively close. Based on this, the shape of the welding strip 106 may be flat, and the flat-shaped welding strip 106 has good bending performance, which is conducive to a lamination process of the photovoltaic module and makes the lamination process easier. In addition, the welding strip 106 is configured to be flat so that the thickness of the welding strip 106 is small. In this way, when the first cover plate 101, the first adhesive film 102, the plurality of cells 103, the second adhesive film 104, and the second cover plate 105 are laminated to form the photovoltaic module, the thickness of the formed photovoltaic module is small, which is conducive to miniaturization of the photovoltaic module. Specifically, in some embodiments, only the shape of the welding strip 106 corresponding to the overlapping portion of the two cells 103 may be flat, and the shape of the welding strip 106 corresponding to unoverlapping portions of the two cells 103 may be any one of circular, rectangular, trapezoidal or triangular. In some embodiments, the shape of the whole welding strip 106 may be configured to be flat.

Referring to FIG. 3, it should be understood that in some embodiments, when the plurality of cells 103 in the photovoltaic module are spaced apart and the plurality of cells 103 are disposed in parallel along a horizontal line, the shape of the welding strip 106 between two adjacent cells 103 may also be configured to be flat. Specifically, in some embodiments, the thickness of the flat-shaped welding strip 106 may be in a range of 100 µm to 150 µm.

In some embodiments, the thickness difference between the first adhesive film 102 and the welding strip 106 or the thickness difference between the second adhesive film 104 and the welding strip 106 is in a range of 50 µm to 180 µm. It should be understood that the thickness difference herein refers to the thickness difference between the welding strip 106 disposed on the surface of the cell 103 and the first adhesive film 102 or the thickness difference between the welding strip 106 disposed on the surface of the cell 103 and the second adhesive film 104. Within this range, the thickness of the first adhesive film 102 or the second adhesive film 104 disposed on the surface of the welding strip 106 is large, so that the first adhesive film 102 or the second adhesive film 104 has a better protective effect on the welding strip 106, and the bonding effect of the first adhesive film 102 or the second adhesive film 104 on the welding strip 106 is better, so that the welding strip 106 is able to be firmly bonded to the surface of the cell 103. In addition, a compression space is able to be provided for the lamination process of the photovoltaic module to prevent damage to the first cover plate or the second cover plate. Within this range, the thickness of the first adhesive film 102 or the second adhesive film 104 disposed on the surface of the welding strip 106 is not excessively large, so that the overall thickness of the first adhesive film 102 and the second adhesive film 104 is small, which is conducive to the preparation of a lightweight photovoltaic module. Specifically, in some embodiments, the thickness of the welding strip 106 may be 260 µm, 280 µm, 300 µm, 315 µm, etc.

The first cover plate 101 and the second cover plate 105 are respectively disposed at opposite sides of the cell 103. The first cover plate 101 may cover the surface of the first adhesive film 102, and the second cover plate 105 may cover the surface of the second adhesive film 104. In some embodiments, the first cover plate 101 may be disposed at a front side of the cell 103, and the second cover plate 105 may be disposed at a rear side of the cell 103. The first cover plate 101 and the second cover plate 105 have good insulation, water resistance, and aging resistance. Therefore, the first cover plate 101 and the second cover plate 105 are disposed at opposite sides of the cell 103 so as to protect and support the cell 103.

With continued reference to FIG. 2, in some embodiments, a material of the first cover plate 101 includes glass, the glass has an embossing structure toward the surface of the cell 103, the embossing structure is recessed in a direction away from the cell 103, and a recess depth of the embossing structure is in a range of 30 µm to 50 µm. Since the glass has good light transmittance, the first cover plate 101 is configured to include glass, so that the absorption effect of the photovoltaic module on the incident light is improved. The embossing structure is disposed on the glass surface, so that the glass surface is a convex surface. In this way, when the incident light incident on the surface of the cell 103 is reflected by the surface of the cell 103, the reflected incident light is diffusely reflected on the embossing structure of the glass surface, so that the reflected incident light is reflected again to the surface of the cell 103 by the embossing structure of the glass surface, so as to enlarge an optical gain of the photovoltaic module, thereby increasing generated power of the photovoltaic module.

The recess depth of the embossing structure is configured to be in a range of 30 µm to 50 µm, which may be, for example, 50 µm. Within this range, the embossing structure has a large degree of concavity, so that the embossing structure has a large degree of roughness, resulting in a good diffuse reflection effect, thereby improving the absorption and utilization of the incident light.

In some embodiments, when the first cover plate 101 includes glass, a material of the second cover plate 105 includes a back plate, the first adhesive film 102 is disposed between the first cover plate 101 and the cell 103, the second adhesive film 104 is disposed between the second cover plate 105 and the cell 103, and the thickness of the second adhesive film 104 is less than or equal to the thickness of the first adhesive film 102. That is, the photovoltaic module is a single glass module. Specifically, in some embodiments, the back plate may be any of a TPC back plate, a PPC back plate, or a CPC back plate. Since the thickness of the glass is larger than the thickness of the back plate, the thickness of the first adhesive film 102 is configured to be larger than the thickness of the second adhesive film 104, thereby prevent the first adhesive film 102 from being damaged due to excessive hardness of the glass during the lamination process.

Since a property of the back plate is different from a property of the glass, in some embodiments, the thickness of the first adhesive film 102 is preferably in a range of 330 µm to 510 µm and the thickness of the second adhesive film 104 is preferably in a range of 310 µm to 500 µm. Within this range, the thickness of the first adhesive film 102 is adapted to the thickness of the glass, and the thickness of the second adhesive film 104 is adapted to the thickness of the back plate, which is conducive to the lamination process. Furthermore, within this range, the thicknesses of the first adhesive film 102 and the second adhesive film 104 are relatively small, which is conducive to the preparation of the lightweight photovoltaic module. In addition, since the thicknesses of the first adhesive film 102 and the second adhesive film 104 are small, absorption of the incident light is further enhanced. Specifically, when the thickness of the first adhesive film 102 is 330 µm, based on the relationship between the first adhesive film 102 and the second adhesive film 104, the thickness of the second adhesive film 104 may be configured to be in a range of 308 µm to 350 µm, and when the thickness of the first adhesive film 102 is 510 µm, the thickness of the second adhesive film 104 may be configured to be in a range of 335 µm to 500 µm. The thicknesses of the first adhesive film 102 and the second adhesive film 104 are configured to satisfy the relationship such that the transmission capability of the first adhesive film 102 to the incident light is adapted to the transmission capability of the second adhesive film 104 to the incident light. In this way, when the incident light is reflected by any one of the first adhesive film 102 and the second adhesive film 104 to the other of the first adhesive film 102 and the second adhesive film 104, the other of the first adhesive film 102 and the second adhesive film 104 is able to transmit most of the reflected incident light again until it is absorbed and utilized by the cell 103, thereby improving the utilization of the incident light by the photovoltaic module.

The incident light first passes through the first cover plate 101 and the second cover plate 105, and then is incident on the first adhesive film 102 and the second adhesive film 104, the incident light reflected by the first adhesive film 102 and the second adhesive film 104 is irradiated on inner surfaces of the first cover plate 101 and the second cover plate 105, and the inner surfaces of the first cover plate 101 and the second cover plate 105 re-reflect the reflected incident light to the surface of the cell 103, thus the adaption of the thickness of the first adhesive film 102 to the thickness of the first cover plate 101 and the adaption of the thickness of the second adhesive film 104 to the thickness of the second cover plate 105 have a large influence on the absorption of the incident light.

Therefore, based on the thickness of the first adhesive film 102 and the thickness of the second adhesive film 104 and properties of the material of the first cover plate 101 and the material of the second cover plate 105, the thickness of the first cover plate 101 may be configured to be in a range of 2.7 mm to 3.2 mm and the thickness of the second cover plate 105 may be configured to be in a range of 0.2 mm to 0.33 mm. In this way, the thickness of the first cover plate 101 is adapted to the thickness of the first adhesive film 102 and the thickness of the second cover plate 105 is adapted to the thickness of the second adhesive film 104, which not only improves a success rate of the lamination process so that the prepared photovoltaic module has better performance, but also makes the absorption capability of the first cover plate 101 for the incident light be adapted to the absorption capability of the first adhesive film 102 for the incident light and makes the absorption capability of the second cover plate 105 for the incident light be adapted to the absorption capability of the second adhesive film 104 for the incident light, thereby improving the absorption and utilization of the incident light by the photovoltaic module.

It should be understood that, in the photovoltaic module provided in the embodiments of the present disclosure, the thicknesses of the first adhesive film 102 and the second adhesive film 104 are configured based on the thickness of the cell 103, and the thicknesses of the first cover plate 101 and the second cover plate 105 are configured based on the thicknesses of the first adhesive film 102 and the second adhesive film 104, i.e., the thickness of the cell 103, the thicknesses of the first cover plate 101 and the second cover plate 105, and the thicknesses of the first adhesive film 102 and the second adhesive film 104 are adapted to each other, so that the absorption and utilization of the incident light by the photovoltaic module is improved, thereby improving the photoelectric conversion performance of the photovoltaic module.

Specifically, when the first cover plate 101 includes the glass and the second cover plate 105 includes the back plate, in some embodiments, the thickness of the cell 103 is 130 µm, the thickness of the first adhesive film 102 is 330 µm, the thickness of the second adhesive film 104 is 308 µm, the thickness of the first cover plate 101 is 2.7 mm, and the thickness of the second cover plate 105 is 0.2 mm. Based on the thicknesses of the first adhesive film 102 and the second adhesive film 104, the thickness of the welding strip 106 on the cell 103 may be 260 µm, and the thickness of the welding strip 106 between two adjacent cells 103 may be 100 µm.

In some embodiments, the thickness of the cell 103 is 150 µm, the thickness of the first adhesive film 102 is 445 µm, the thickness of the second adhesive film 104 is 431 µm, the thickness of the first cover plate 101 is 2.95 mm, and the thickness of the second cover plate 105 is 0.265 mm. Based on the thicknesses of the first adhesive film 102 and the second adhesive film 104, the thickness of the welding strip 106 on the cell 103 may be 280 µm, and the thickness of the welding strip 106 between two adjacent cells 103 may be 125 µm.

In some embodiments, the thickness of the cell 103 is 155 µm, the thickness of the first adhesive film 102 is 461 µm, the thickness of the second adhesive film 104 is 450 µm, the thickness of the first cover plate 101 is 3 mm, and the thickness of the second cover plate 105 is 0.28 mm. Based on the thicknesses of the first adhesive film 102 and the second adhesive film 104, the thickness of the welding strip 106 on the cell 103 may be 300 µm, and the thickness of the welding strip 106 between two adjacent cells 103 may be 135 µm.

In some embodiments, the thickness of the cell 103 is 167 µm, the thickness of the first adhesive film 102 is 510 µm, the thickness of the second adhesive film 104 is 385 µm, the thickness of the first cover plate 101 is 3.2 mm, and the thickness of the second cover plate 105 is in a range of 0.3 mm to 0.33 mm. Specifically, in some embodiments, the second cover 105 may be any one of the TPC back plate, the PPC back plate, or the CPC back plate. When the second cover plate 105 is the TPC back plate, the thickness of the second cover plate 105 may be 0.32 mm. When the second cover plate 105 is the PPC back plate, the thickness of the second cover plate 105 may be 0.315 mm. When the second cover plate 105 is the CPC back plate, the thickness of the second cover plate 105 may be 0.305 mm. Based on the thicknesses of the first adhesive film 102 and the second adhesive film 104, the thickness of the welding strip 106 on the cell 103 may be 315 µm, and the thickness of the welding strip 106 between two adjacent cells 103 may be 150 µm.

In some embodiments, when the first cover plate 101 includes the glass, the material of the second cover plate 105 may also include glass. In other words, the photovoltaic module is a double-glass module, and the structure of the double-glass module is symmetrical because both sides of the cell 103 of the double-glass module are provided with glass, so that both sides of the cell 103 have the same weight, which effectively improves mechanical strength, thereby better protecting the cell 103.

Based on the configuration of the double-glass module, in some embodiments, the thickness of the first adhesive film 102 is in a range of 310 µm to 500 µm and the thickness of the second adhesive film 104 is in a range of 310 µm to 520 µm. Within this range, the adaption of the first adhesive film 102 to the glass and the adaption of the second adhesive film 104 to the glass are better, i.e., the first adhesive film 102 and the second adhesive film 104 are able to be relatively thin, and the first adhesive film 102 or the second adhesive film 104 is able to be prevented from being damaged due to the large hardness of the glass during the lamination process.

Based on the thickness of the first adhesive film 102 and the thickness of the second adhesive film 104 and properties of the material of the first cover plate 101 and the material of the second cover plate 105, the thickness of the first cover plate 101 and the thickness of the second cover plate 105 may be configured to be in a range of 1.5 mm to 2 mm. That is, the thickness of the first cover plate 101 and the second cover plate 105 may be the same. Since the materials of the first cover plate 101 and the second cover plate 105 are the same, the thicknesses of the first cover plate 101 and the second cover plate 105 are configured to be the same so that weights of the first cover plate 101 and the second cover plate 105 are similar or the same, and weights at the two sides of the cell 103 are similar, which is conducive to maintaining the balance of the photovoltaic module, thereby improving of the mechanical strength and mounting stability of the photovoltaic module.

In some embodiments, when both the first cover plate 101 and the second cover plate 105 include the glass, the thickness of the cell 103 is 130 µm, the thickness of the first adhesive film 102 is 310 µm, the thickness of the second adhesive film 104 is 310 µm, the thickness of the first cover plate 101 is 1.5 mm, and the thickness of the second cover plate 105 is 1.5 mm. Based on the thicknesses of the first adhesive film 102 and the second adhesive film 104, the thickness of the welding strip 106 on the cell 103 may be 260 µm, and the thickness of the welding strip 106 between two adjacent cells 103 may be 100 µm.

In some embodiments, the thickness of the cell 103 is 150 µm, the thickness of the first adhesive film 102 is 415 µm, the thickness of the second adhesive film 104 is 396 µm, the thickness of the first cover plate 101 is 1.75 mm, and the thickness of the second cover plate 105 is 1.75 mm. Based on the thicknesses of the first adhesive film 102 and the second adhesive film 104, the thickness of the welding strip 106 on the cell 103 may be 290 µm, and the thickness of the welding strip 106 between two adjacent cells 103 may be 125 µm.

In some embodiments, the thickness of the cell 103 is 155 µm, the thickness of the first adhesive film 102 is 440 µm, the thickness of the second adhesive film 104 is 468 µm, the thickness of the first cover plate 101 is 1.81 mm, and the thickness of the second cover plate 105 is 1.81 mm. Based on the thicknesses of the first adhesive film 102 and the second adhesive film 104, the thickness of the welding strip 106 on the cell 103 may be 300 µm, and the thickness of the welding strip 106 between two adjacent cells 103 may be 131 µm.

In some embodiments, the thickness of the cell 103 is 167 µm, the thickness of the first adhesive film 102 is 500 µm, the thickness of the second adhesive film 104 is 520 µm, the thickness of the first cover plate 101 is 2 mm, and the thickness of the second cover plate 105 is 2 mm. Based on the thicknesses of the first adhesive film 102 and the second adhesive film 104, the thickness of the welding strip 106 on the cell 103 may be 315 µm, and the thickness of the welding strip 106 between two adjacent cells 103 may be 150 µm.

In some embodiments, when both the first cover plate 101 and the second cover plate 105 include the glass, the thickness of the first cover plate 101 and the thickness of the second cover plate 105 may be different. For example, the thickness of the first cover plate 101 is greater than the thickness of the second cover plate 105. Specifically, the thickness of the first cover plate 101 may be in a range of 1.8 mm to 2 mm, and the thickness of the second cover plate 105 may be in a range of 1.5 mm to 1.7 mm.

Specifically, in some embodiments, the thickness of the cell 103 is 155 µm, the thickness of the first adhesive film 102 is 440 µm, the thickness of the second adhesive film 104 is 468 µm, the thickness of the first cover plate 101 is 1.8 mm, and the thickness of the second cover plate 105 is 1.5 mm.

In some embodiments, the thickness of the cell 103 is 167 µm, the thickness of the first adhesive film 102 is 500 µm, the thickness of the second adhesive film 104 is 500 µm, the thickness of the first cover plate 101 is 2 mm, and the thickness of the second cover plate 105 is 1.7 mm.

In the combination of the above different embodiments, the thickness of the first adhesive film 102 and the thickness of the second adhesive film 104 are configured based on the thickness of the cell 103, and the thickness of the first adhesive film 102 and the thickness of the second adhesive film 104 satisfy the following relationship: 0.0007x²-0.4297x+374.2≤y≤0.0034x²-1.0297x+314.19, so that the thicknesses of the first adhesive film 102 and the second adhesive film 104 are adapted to the thickness of the cell 103, and the thickness of the first adhesive film 102 is adapted to the thickness of the second adhesive film 104, so that optical properties of the first adhesive film 102 and the second adhesive film 104 are adapted to each other, and the incident light is further able to be transmitted through the first adhesive film 102 and the second adhesive film 104 and irradiated onto the surface of the cell 103. Furthermore, the thickness of the first cover plate 101, the thickness of the second cover plate 105 and the thickness of the welding strip 106 are configured based on the thicknesses of the first adhesive film 102 and the second adhesive film 104, and in the photovoltaic module obtained therefrom, the thickness of the cell 103, the thicknesses of the first cover plate 101 and the second cover plate 105, and the thicknesses of the first adhesive film 102 and the second adhesive film 104 are all adapted to each other, so that the photovoltaic module has a high absorption and utilization rate for the incident light, and the photoelectric conversion performance of the photovoltaic module is improved.

In the photovoltaic module provided in the above embodiments, under the condition that the thickness of the cell 103 is in a range of 100 µm to 170 µm, the thickness of the first adhesive film 102 is in a range of 300 µm to 550 µm, and the thickness of the second adhesive film 104 is in a range of 300 µm to 710 µm, the thickness of the first adhesive film 102 and the thickness of the second adhesive film 104 satisfy the following relationship: 0.0007x²-0.4297x+374.2≤y≤0.0034x²-1.0297x+314.19, where x is denoted as the thickness of the first adhesive film 102 and y is denoted as the thickness of the second adhesive film 104. In this way, the thickness of the first adhesive film 102 and the thickness of the second adhesive film 104 are adapted to the cell 103, respectively, so that the first adhesive film 102 and the second adhesive film 104 have stronger absorption capability for the incident light, and the absorption and utilization of the incident light by the cell 103 is improved, thereby improving the photoelectric conversion performance of the photovoltaic module. Furthermore, the thickness of the welding strip 106 is configured to be in a range of 200 µm to 400 µm so that the thickness of the welding strip 106 is adapted to the thicknesses of the first adhesive film 102 and the second adhesive film 104, thus the first adhesive film 102 and the second adhesive film 104 disposed on the surface of the welding strip 106 have better absorption capacities for the incident light.

The embodiments of the present disclosure described above are not intended to limit the claims. Any one of those skilled in the art may make several possible changes and modifications without departing from the concept of the present disclosure. Therefore, the protection scope of the present disclosure shall be subject to the scope defined in the claims of the present disclosure.

Those of ordinary skill in the art should appreciate that the embodiments described above are specific embodiments of the present disclosure, and in practical application, various changes may be made thereto in form and detail without departing from the scope of the present disclosure. Any one of those skilled in the art may make their own changes and modifications without departing from the scope of the present disclosure. Therefore, the protection scope of the present disclosure shall be subject to the scope defined in the claims.

## Claims

1. A photovoltaic module, comprising:
a first cover plate (101), a first adhesive film (102), a plurality of cells (103), a second adhesive film (104), and a second cover plate (105);
wherein a thickness of each respective cell of the plurality of cells (103) is in a range of 100 µm to 170 µm, a thickness of the first adhesive film (102) is in a range of 300 µm to 550 µm, a thickness of the second adhesive film (104) is in a range of 300 µm to 710 µm, and the thickness of the first adhesive film (102) and the thickness of the second adhesive film (104) satisfy the following relationship: 0.0007x²-0.4297x+374.2≤y≤0.0034x²-1.0297x+314.19, wherein x is denoted as the thickness of the first adhesive film (102), and y is denoted as the thickness of the second adhesive film (104);
the photovoltaic module further comprising at least one welding strip (106), wherein for each respective welding strip (106) of the at least one welding strip (106), one end of the each respective welding strip (106) is disposed on a front surface of one of two adjacent cells (103) in the plurality of cells (103), and the other end of the each respective welding strip (106) is disposed on a rear surface of the other of the two adjacent cells (103), wherein a thickness of the each respective welding strip (106) is in a range of 200 µm to 400 µm;
**characterized in that** the first cover plate (101) is made of glass, has a first surface facing the plurality of cells (103), and is provided with an embossing structure on the first surface, the embossing structure is recessed in a direction away from the each respective cell (103), and a recess depth of the embossing structure is in a range of 30 µm to 50 µm.

2. The photovoltaic module according to claim 1, wherein at least one of a thickness difference between the each respective cell (103) and the first adhesive film (102) and a thickness difference between the each respective cell (103) and the second adhesive film (104) is in a range of 200 µm to 350 µm.

3. The photovoltaic module according to any one of claims 1 to 2, wherein a material of the second cover plate (105) includes a back plate, the first adhesive film (102) is disposed between the first cover plate (101) and the plurality of cells (103), the second adhesive film (104) is disposed between the second cover plate (105) and the plurality of cells (103), and the thickness of the second adhesive film (104) is less than or equal to the thickness of the first adhesive film (102).

4. The photovoltaic module according to any one of claims 1 to 3, wherein a thickness of the first cover plate (101) is in a range of 2.7 mm to 3.2 mm, and a thickness of the back plate is in a range of 0.2 mm to 0.33 mm.

5. The photovoltaic module according to any one of claims 1 to 4, wherein the thickness of the first adhesive film (102) is in a range of 330 µm to 510 µm, and the thickness of the second adhesive film (104) is in a range of 310 µm to 500 µm.

6. The photovoltaic module according to claim 1, wherein a material of the second cover plate (105) includes glass.

7. The photovoltaic module according to claim 6, wherein both a thickness of the first cover plate (101) and a thickness of the second cover plate (105) are in a range of 1.5 mm to 2 mm.

8. The photovoltaic module according to claim 6 or claim 7, wherein the thickness of the first adhesive film (102) is in a range of 310 µm to 500 µm, and the thickness of the second adhesive film (104) is in a range of 310 µm to 520 µm.

9. The photovoltaic module according to any one of claims 1 to 8, wherein one of a thickness difference between the each respective welding strip (106) and the first adhesive film (102) and a thickness difference between the each respective welding strip (106) and the second adhesive film (104) is in a range of 50 µm to 180 µm.

10. The photovoltaic module according to any one of claims 1 to 9, wherein the first adhesive film (102) includes at least one of a poly olefin elastomer, POE adhesive film and an ethylene vinyl acetate, EVA, adhesive film, and the second adhesive film (104) includes at least one of the POE adhesive film and the EVA adhesive film.

11. The photovoltaic module according to claim 10, wherein the thickness of the first adhesive film (102) is equal to the thickness of the second adhesive film (104) when both the first adhesive film (102) and the second adhesive film (104) include POE adhesive films.

12. The photovoltaic module according to any one of claims 6 to 11, wherein a thickness of the first cover plate (101) is greater than a thickness of the second cover plate (105);
preferably, the thickness of the first cover plate (101) is in a range of 1.8 mm to 2 mm, and the thickness of the second cover plate (105) is in a range of 1.5 mm to 1.7 mm.

13. The photovoltaic module according to any one of claims 1 to 12, wherein a shape of the each respective welding strip (106) is any one of circular, rectangular, trapezoidal and triangular.

14. The photovoltaic module according to any one of claims 1 to 13, wherein adjacent two cells (103) in the plurality of cells (103) are partially overlapped, and a shape of a portion of the each respective welding strip (106) corresponding to an overlapping portion of the adjacent two cells (103) is flat;
optionally, the plurality of cells (103)are disposed in parallel to each other, and a shape of a portion of the each respective welding strip (106) disposed between two parallel cells (103) in the plurality of cells (103) is flat.

## Patentansprüche

1. Photovoltaikmodul, umfassend:
eine erste Deckplatte (101), eine erste Klebefolie (102), eine Vielzahl von Zellen (103), eine zweite Klebefolie (104) und eine zweite Deckplatte (105);
wobei eine Dicke jeder jeweiligen Zelle der Vielzahl von Zellen (103) in einem Bereich von 100 µm bis 170 µm liegt, eine Dicke der ersten Klebefolie (102) in einem Bereich von 300 µm bis 550 µm liegt, eine Dicke der zweiten Klebefolie (104) in einem Bereich von 300 µm bis 710 µm liegt, und die Dicke der ersten Klebefolie (102) und die Dicke der zweiten Klebefolie (104) folgende Beziehung erfüllen: 0,0007x² - 0,4297x + 374,2 ≤ y ≤ 0,0034x² - 1,0297x + 314,19, wobei x die Dicke der ersten Klebefolie (102) ist, und y die Dicke der zweiten Klebefolie (104) ist;
wobei das Photovoltaikmodul ferner mindestens einen Schweißstreifen (106) umfasst, wobei für jeden jeweiligen Schweißstreifen (106) des mindestens einen Schweißstreifens (106) ein Ende jedes jeweiligen Schweißstreifenes (106) auf einer Vorderfläche einer von zwei aneinandergrenzenden Zellen (103) der Vielzahl von Zellen (103) angeordnet ist, und das andere Ende jedes jeweiligen Schweißstreifenes (106) auf einer Rückfläche der anderen der beiden aneinandergrenzenden Zellen (103) angeordnet ist, wobei eine Dicke jedes jeweiligen Schweißstreifenes (106) in einem Bereich von 200 µm bis 400 µm liegt;
**dadurch gekennzeichnet, dass** die erste Deckplatte (101) aus Glas besteht, eine erste Oberfläche aufweist, die der Vielzahl von Zellen (103) gegenübersteht, und mit einer Prägestruktur auf der ersten Oberfläche versehen ist, die Prägestruktur in einer Richtung, die sich von jeder jeweiligen Zelle (103) entfernt, ausgespart ist, und eine Ausspartiefe der Prägestruktur in einem Bereich von 30 µm bis 50 µm liegt.

2. Photovoltaikmodul nach Anspruch 1, wobei mindestens eine von einer Dickendifferenz zwischen jeder jeweiligen Zelle (103) und der ersten Klebefolie (102) und einer Dickendifferenz zwischen jeder jeweiligen Zelle (103) und der zweiten Klebefolie (104) in einem Bereich von 200 µm bis 350 µm liegt.

3. Photovoltaikmodul nach einem der Ansprüche 1 bis 2, wobei ein Material der zweiten Deckplatte (105) eine hintere Platte umfasst, die erste Klebefolie (102) zwischen der ersten Deckplatte (101) und der Vielzahl von Zellen (103) angeordnet ist, die zweite Klebefolie (104) zwischen der zweiten Deckplatte (105) und der Vielzahl von Zellen (103) angeordnet ist, und die Dicke der zweiten Klebefolie (104) kleiner oder gleich der Dicke der ersten Klebefolie (102) ist.

4. Photovoltaikmodul nach einem der Ansprüche 1 bis 3, wobei eine Dicke der ersten Deckplatte (101) in einem Bereich von 2,7 mm bis 3,2 mm liegt, und eine Dicke der hinteren Platte in einem Bereich von 0,2 mm bis 0,33 mm liegt.

5. Photovoltaikmodul nach einem der Ansprüche 1 bis 4, wobei die Dicke der ersten Klebefolie (102) in einem Bereich von 330 µm bis 510 µm liegt, und die Dicke der zweiten Klebefolie (104) in einem Bereich von 310 µm bis 500 µm liegt.

6. Photovoltaikmodul nach Anspruch 1, wobei ein Material der zweiten Deckplatte (105) Glas umfasst.

7. Photovoltaikmodul nach Anspruch 6, wobei sowohl eine Dicke der ersten Deckplatte (101) als auch eine Dicke der zweiten Deckplatte (105) in einem Bereich von 1,5 mm bis 2 mm liegen.

8. Photovoltaikmodul nach Anspruch 6 oder Anspruch 7, wobei die Dicke der ersten Klebefolie (102) in einem Bereich von 310 µm bis 500 µm liegt, und die Dicke der zweiten Klebefolie (104) in einem Bereich von 310 µm bis 520 µm liegt.

9. Photovoltaikmodul nach einem der Ansprüche 1 bis 8, wobei eine von einer Dickendifferenz zwischen jedem jeweiligen Schweißstreifen (106) und der ersten Klebefolie (102) und einer Dickendifferenz zwischen jedem jeweiligen Schweißstreifen (106) und der zweiten Klebefolie (104) in einem Bereich von 50 µm bis 180 µm liegt.

10. Photovoltaikmodul nach einem der Ansprüche 1 bis 9, wobei die erste Klebefolie (102) mindestens eine von einer Polyolefin-Elastomer-, POE, Klebefolie und einer Ethylenvinylacetat-, EVA, Klebefolie umfasst, und die zweite Klebefolie (104) mindestens eine von der POE-Klebefolie und der EVA-Klebefolie umfasst.

11. Photovoltaikmodul nach Anspruch 10, wobei die Dicke der ersten Klebefolie (102) gleich der Dicke der zweiten Klebefolie (104) ist, wenn sowohl die erste Klebefolie (102) als auch die zweite Klebefolie (104) POE-Klebefolien umfassen.

12. Photovoltaikmodul nach einem der Ansprüche 6 bis 11, wobei eine Dicke der ersten Deckplatte (101) größer als eine Dicke der zweiten Deckplatte (105) ist;
wobei bevorzugt die Dicke der ersten Deckplatte (101) in einem Bereich von 1,8 mm bis 2 mm liegt, und die Dicke der zweiten Deckplatte (105) in einem Bereich von 1,5 mm bis 1,7 mm liegt.

13. Photovoltaikmodul nach einem der Ansprüche 1 bis 12, wobei eine Form jedes jeweiligen Schweißstreifenes (106) eine von kreisförmig, rechteckig, trapezförmig und dreieckig ist.

14. Photovoltaikmodul nach einem der Ansprüche 1 bis 13, wobei zwei aneinandergrenzende Zellen (103) der Vielzahl von Zellen (103) sich teilweise überlappen, und eine Form eines Teils jedes jeweiligen Schweißstreifenes (106), der einem Überlappungsteil der beiden aneinandergrenzenden Zellen (103) entspricht, flach ist;
wobei wahlweise die Vielzahl von Zellen (103) parallel zueinander angeordnet ist, und eine Forme eines Teils jedes jeweiligen Schweißstreifenes (106), der zwischen zwei parallelen Zellen (103) der Vielzahl von Zellen (103) angeordnet ist, flach ist.

## Revendications

1. Module photovoltaïque, comprenant :
une première plaque de recouvrement (101), un premier film adhésif (102), une pluralité de cellules (103), un deuxième film adhésif (104), et une deuxième plaque de recouvrement (105) ;
dans lequel une épaisseur de chaque cellule respective de la pluralité de cellules (103) se situe dans une plage de 100 µm à 170 pm, une épaisseur du premier film adhésif (102) se situe dans une plage de 300 µm à 550 pm, une épaisseur du deuxième film adhésif (104) se situe dans une plage de 300 µm à 710 pm, et l'épaisseur du premier film adhésif (102) et l'épaisseur du deuxième film adhésif (104) satisfont la relation suivante : 0,0007x²- 0,4297x + 374,2 ≤ y ≤ 0,0034x² - 1,0297x + 314,19, où x désigne l'épaisseur du premier film adhésif (102) et y désigne l'épaisseur du deuxième film adhésif (104) ;
le module photovoltaïque comprenant en outre au moins une bande de soudure (106), dans lequel pour chaque bande de soudure (106) respective de ladite au moins une bande de soudure (106), une extrémité de chaque bande de soudure (106) respective est disposée sur une surface avant d'une des deux cellules adjacentes (103) de la pluralité de cellules (103), et l'autre extrémité de chaque bande de soudure (106) respective est disposée sur une surface arrière de l'autre des deux cellules adjacentes (103), dans lequel une épaisseur de chaque bande de soudure (106) respective se situe dans une plage de 200 µm à 400 µm ;
**caractérisé en ce que** la première plaque de recouvrement (101) est composée de verre, présente une première surface opposée à la pluralité de cellules (103) et est munie d'une structure embossée sur la première surface, la structure embossée est enfoncée dans une direction s'éloignant de chaque cellule respective (103) et une profondeur d'enfoncement de la structure embossée se situe dans une plage de 30 µm à 50 µm.

2. Module photovoltaïque selon la revendication 1, dans lequel au moins l'une d'une différence d'épaisseur entre chaque cellule respective (103) et le premier film adhésif (102) et une différence d'épaisseur entre chaque cellule respective (103) et le deuxième film adhésif (104) se situe dans une plage de 200 µm à 350 µm.

3. Module photovoltaïque selon l'une quelconque des revendications 1 à 2, dans lequel un matériau de la deuxième plaque de recouvrement (105) comprend une plaque arrière, le premier film adhésif (102) est disposé entre la première plaque de recouvrement (101) et la pluralité de cellules (103), le deuxième film adhésif (104) est disposé entre la deuxième plaque de recouvrement (105) et la pluralité de cellules (103), et l'épaisseur du deuxième film adhésif (104) est inférieure ou égale à l'épaisseur du premier film adhésif (102).

4. Module photovoltaïque selon l'une quelconque des revendications 1 à 3, dans lequel une épaisseur de la première plaque de recouvrement (101) se situe dans une plage de 2,7 mm à 3,2 mm, et une épaisseur de la plaque arrière se situe dans une plage de 0,2 mm à 0,33 mm.

5. Module photovoltaïque selon l'une quelconque des revendications 1 à 4, dans lequel l'épaisseur du premier film adhésif (102) se situe dans une plage de 330 µm à 510 µm, et l'épaisseur du deuxième film adhésif (104) se situe dans une plage de 310 µm à 500 µm.

6. Module photovoltaïque selon la revendication 1, dans lequel un matériau de la deuxième plaque de recouvrement (105) comprend du verre.

7. Module photovoltaïque selon la revendication 6, dans lequel à la fois une épaisseur de la première plaque de recouvrement (101) et une épaisseur de la deuxième plaque de recouvrement (105) se situent dans une plage de 1,5 mm à 2 mm.

8. Module photovoltaïque selon la revendication 6 ou la revendication 7, dans lequel l'épaisseur du premier film adhésif (102) se situe dans une plage de 310 µm à 500 µm, et l'épaisseur du deuxième film adhésif (104) se situe dans une plage de 310 µm à 520 µm.

9. Module photovoltaïque selon l'une quelconque des revendications 1 à 8, dans lequel l'une d'une différence d'épaisseur entre chaque bande de soudure (106) respective et le premier film adhésif (102) et une différence d'épaisseur entre chaque bande de soudure (106) respective et le deuxième film adhésif (104) se situe dans une plage de 50 µm à 180 µm.

10. Module photovoltaïque selon l'une quelconque des revendications 1 à 9, dans lequel le premier film adhésif (102) comprend au moins l'un d'un film adhésif d'élastomère de polyoléfine, POE, et d'un film adhésif d'éthylène-acétate de vinyle, EVA, et le deuxième film adhésif (104) comprend au moins l'un du film adhésif POE et du film adhésif EVA.

11. Module photovoltaïque selon la revendication 10, dans lequel l'épaisseur du premier film adhésif (102) est égale à l'épaisseur du deuxième film adhésif (104) quand à la fois le premier film adhésif (102) et le deuxième film adhésif (104) comprennent des films adhésifs POE.

12. Module photovoltaïque selon l'une quelconque des revendications 6 à 11, dans lequel une épaisseur de la première plaque de recouvrement (101) est supérieure à une épaisseur de la deuxième plaque de recouvrement (105) ;
dans lequel de préférence l'épaisseur de la première plaque de recouvrement (101) se situe dans une plage de 1,8 mm à 2 mm, et l'épaisseur de la deuxième plaque de recouvrement (105) se situe dans une plage de 1,5 mm à 1,7 mm.

13. Module photovoltaïque selon l'une quelconque des revendications précédentes 1 à 12, dans lequel une forme de chaque bande de soudure (106) respective est l'une parmi circulaire, rectangulaire, trapézoïdale et triangulaire.

14. Module photovoltaïque selon l'une quelconque des revendications 1 à 13, dans lequel deux cellules (103) adjacentes de la pluralité de cellules (103) se chevauchent partiellement, et une forme d'une partie de chaque bande de soudure (106) respective correspondant à une partie de chevauchement des deux cellules adjacentes (103) est plate ;
dans lequel en option, la pluralité de cellules (103) est disposée en parallèle les unes aux autres, et une forme d'une partie de chaque bande de soudure (106) respective disposée entre deux cellules parallèles (103) de la pluralité de cellules (103) est plate.
